# EUROPÄISCHE PATENTSCHRIFT

(11) **EP 1 218 145 B1**
(45) Veröffentlichungstag und Bekanntmachung des Hinweises auf die Patenterteilung: **20.10.2004**
(21) Anmeldenummer: 00960478.6
(22) Anmeldetag: 17.08.2000
(51) Int. Cl.: B24C 1/06, B24C 3/04, C23C 14/02

(54) **VERFAHREN UND VORRICHTUNG ZUR OBERFLÄCHENBEHANDLUNG EINES BAUTEILS**
METHOD AND DEVICE FOR TREATING THE SURFACE OF A PART
PROCEDE ET DISPOSITIF DE TRAITEMENT DE SURFACE D'UN ELEMENT

(30) Priorität: 01.09.1999 EP 99117220
(43) Veröffentlichungstag der Anmeldung: 03.07.2002
(73) Patentinhaber: SIEMENS AKTIENGESELLSCHAFT, 80333 München (DE)
(72) Erfinder: DÖPPER, Gebhard, 74423 Obersontheim (DE)
(86) Internationale Anmeldenummer: PCT/EP2000/008049
(87) Internationale Veröffentlichungsnummer: WO 2001/015866

(56) Entgegenhaltungen:
- EP-A- 0 385 484
- FR-A- 2 590 827
- US-A- 4 321 310
- US-A- 5 645 893
- US-A- 5 704 824

## Beschreibung

Die Erfindung betrifft ein Verfahren zur Oberflächenbehandlung eines Bauteils mit einer gekrümmten Bauteiloberfläche, bei dem mittels eines aus einer Partikelquelle erzeugten Partikelstrahls Material von der Bauteiloberfläche abgetragen wird. Die Erfindung betrifft weiterhin eine Vorrichtung zur Oberflächenbehandlung eines Bauteils mit einer gekrümmten Bauteiloberfläche.

In dem Buch "Plasma Spraying of Metallic and Ceramic Materials" von D. Matejka und B. Benko, John Wiley & Sons, Chichester, U.K., 1989, ist das Verfahren des Plasmaspritzens mit Anwendungen, beispielsweise auf Komponenten eines Verbrennungsmotors eines Kraftfahrzeugs, angegeben. In dem Abschnitt 6.1 "Preliminary preparation of surface prior to spraying" werden verschiedene Verfahren beschrieben, durch die eine Vorabbearbeitung eines zu beschichtenden Bauteils erfolgt. Hierin ist ein Verfahren zur Reinigung der Oberfläche des Erzeugnisses vor der eigentlichen Beschichtung mittels eines Strahls von abrasiv wirkenden Partikeln beschrieben. Die abrasiv wirkenden Partikel werden in einem Preßluftstrom mitgeführt und prallen vorzugsweise senkrecht auf die zu behandelnde Oberfläche auf. Die Bestrahlung mit den abrasiv wirkenden Partikeln kann in einer Kammer oder mit einer Saugeinrichtung durchgeführt werden, so daß im wesentlichen die gesamte Menge der abrasiv wirkenden Partikel wiedergewonnen und erneut für eine Bestrahlung zur Verfügung steht:. Abrasiv wirkende Partikel können hierbei aus Gußeisen, Stahl, aus synthetischem Korund (Aluminiumoxid Al₂O₃), Siliciumkarbid oder Silikatsand (Quartzsand) hergestellt werden. Die abrasiv wirkenden Partikel können einen Durchmesser zwischen 350 µm und 1400 µm aufweisen. Vorzugsweise wird die Bestrahlung mittels des sogenannten Grobsandstrahlens durchgeführt, wobei die abrasiven Partikel Korundpartikel mit einem Durchmesser zwischen 200 µm und 800 µm sind. Diese werden verwendet für die Vorbereitung einer Oberfläche mit einer Beschichtung, die eine Schichtdicke von bis zu 200 µm aufweist, welche Beschichtung in einem Beschichtungsprozeß auf die präparierte Oberfläche aufgebracht wird. Für Beschichtungen mit größerer Schichtdicke werden Partikeldurchmesser von bis zu 1400 µm verwendet. Die Preßluft, in welcher die abrasiv wirkenden Partikel mitgeführt werden, hat bei der Verwendung von Korund vorzugsweise einen Druck von bis zu 0,35 MPa.

In der US-Patentschrift 4,321,310 ist ein Verfahren zur Herstellung einer Beschichtung auf einem Gasturbinenbauteil, welches eine Turbinenschaufel ist, beschrieben. Die Turbinenschaufel weist einen Grundkörper aus einem Grundmaterial auf. Als Grundmaterial wird eine Kobaltbasis- oder Nickelbasislegierung, wie beispielsweise IN 100, MAR M200, MAR M509 oder WI 52 eingesetzt. Auf dieses Grundmaterial wird eine Haftvermittlerschicht der Art MCrAlY aufgebracht. Dabei bezeichnet M beispielsweise eine Kombination der Metalle Nickel und Kobalt. Cr steht für Chrom und Al für Aluminium sowie Y für Yttrium. Auf diese Haftvermittlerschicht wird eine keramische Schicht aus Zirkonoxid aufgebracht, die stengelförmig aufgewachsen ist, wobei die Stengel im wesentlichen senkrecht zur Oberfläche des Grundkörpers gerichtet sind. Vor dem Aufbringen der als Wärmedämmschicht dienenden Zirkonoxidschicht auf die Haftvermittlerschicht wird die Haftvermittlerschicht poliert, bis sich eine Oberflächenrauhigkeit von etwa 1 µm einstellt.

Aus der US-Patentschrift 5,683,825 geht ebenfalls ein Verfahren zum Aufbringen einer Wärmedämmschicht auf ein Bauteil einer Gasturbine hervor. Auf einem Grundkörper wird durch Niederdruckplasmaspritzen eine NiCrAlY Haftvermittlerschicht aufgebracht. Die Oberfläche der Haftvermittlerschicht wird poliert, so daß diese eine Oberflächenrauhigkeit von etwa 2 µm aufweist. Auf die so polierte Haftvermittlerschicht wird mittels eines Aufdampfverfahrens (PVD, Physical Vapor Deposition) eine keramische Wärmedämmschicht aus mit: Yttrium stabilisiertem Zirkonoxid aufgebracht. Vorzugsweise wird die Wärmedämmschicht hierbei mit dem sogenannten Elektronenstrahl-PVD-Verfahren aufgebracht. Die Wärmedämmschicht kann auch mittels Plasmaspritzens aufgebracht werden. In der US-Patentschrift 5,498,484 wird ebenfalls das Aufbringen einer Wärmedämmschicht auf eine Haftvermittlerschicht eines Bauteils einer Gasturbine beschrieben. Die mittlere Oberflächenrauhigkeit der Haftvermittlerschicht wird mit zumindest über 10 µm angegeben.

Die US-Patentschrift 5,645,893 betrifft ein beschichtetes Bauteil mit einem Grundkörper aus einer Superlegierung sowie mit einer Haftvermittlerschicht und einer Wärmedämmschicht. Die Haftvermittlerschicht weist ein Platinaluminid sowie eine daran sich anschließende dünne Oxidschicht auf. Die dünne Oxidschicht weist Aluminiumoxid auf. An diese Oxidschicht grenzt die Wärmedämmschicht an, welche mittels dem Elektronenstrahl-PVD-Verfahren aufgebracht wird. Dabei wird mit Yttrium stabilisiertes Zirkonoxid auf die Haftvermittlerschicht aufgebracht. Vor dem Aufbringen der Haftvermititlerschicht wird die Oberfläche des Grundkörpers mittels eines Grobsandstrahlverfahrens gereinigt. Zur materialabtragenden Bearbeitung des Grundkörpers wird dabei Aluminiumoxidsand eingesetzt.

Aus der WO 97/047781 A1 geht eine Gasturbinenkomponente, z.B. eine Gasturbinenschaufel oder ein Hitzeschildelement einer Brennkammer, hervor. Die Gasturbinenkomponente weist als Grundwerkstoff eine Nickelbasis- oder Kobaltbasis-Superlegierung auf. Auf den Grundwerkstoff ist eine Anbindungsschicht mit einem Nitrid aufgebracht. An die Anbindungsschicht schließt sich eine keramische Wärmedämmschicht an. Die Oberfläche der Anbindungsschicht weist eine mittlere Oberflächenrauhigkeit von über 6 µm, insbesondere zwischen 9 µm und 14 µm, auf.

In der WO 99/23272 ist ein Verfahren zur Herstellung einer Schutzschicht auf einen für eine Heißgasbeaufschlagung ausgelegten Grundkörper zum Schutz vor Oxidation und/oder Korrosion beschrieben. Dabei wird die Schutzschicht durch ein heißisostatisches Preßverfahren verdichtet, wobei sie unversiegelt bleibt. Dabei bleibt die Schutzschicht im wesentlichen chemisch unverändert. Beim heißisostatischen Pressen wird über einen von einem Preßgas ausgeübten Druck die poröse Schutzschicht über eine Zeitdauer zwischen etwa 0,1 bis 3 Stunden bei Temperaturen von etwa 800 °C bis 1200 °C verdichtet. Im Gegensatz zu den vorgenannten Schriften liegt beim heißisostatischen Pressen eine nicht-materialabtragende Oberflächenbehandlung vor.

Die EP 0 385 484 A1 offenbart ein Verfahren zur Oberflächenbehandlung eines Bauteils, bei dem durch ortsfeste Position der Strahlquelle und des Bauteils die Strahlparameter Abstrahl- und Einstrahlwinkel über das gesamte Verfahren konstant gehalten werden. Die Position der Strahlquelle des Bauteils zueinander ist also vor der Oberflächenbehandlung fest eingestellt.

Die US-PS 5,704,824 offenbart eine Vorrichtung zur Oberflächenbehandlung eines Bauteils, wobei die Strahlquelle in x.y und z-Richtung bewegt und um eine Achse gedreht wird.

Aufgabe der Erfindung ist es, ein Verfahren zur Oberflächenbehandlung eines Bauteils anzugeben. Eine weitere Aufgabe der Erfindung ist es, eine Vorrichtung zur Oberflächenbehandlung eines Bauteils anzugeben.

Die auf ein Verfahren gerichtete Aufgabe wird erfindungsgemäß gelöst durch ein Verfahren zur Oberflächenbehandlung eines Bauteils mit einer gekrümmten Bauteiloberfläche, bei dem mittels eines aus einer Partikelquelle erzeugten Partikelstrahls, welcher durch die Strahlparameter Einstrahlabstand, Einstrahlintensität, Einstrahlwinkel und Einstrahldauer charakterisiert ist, Material von der Bauteiloberfläche entlang einer Konturlinie auf der Bauteiloberfläche abgetragen wird, wobei zumindest einmal zumindest einer der Strahlparameter gezielt so an die Konturlinie angepaßt wird, daß sich entlang der Konturlinie eine homogene Oberflächenrauhigkeit einstellt.

Die Erfindung geht von der Überlegung aus, daß sich Unregelmäßigkeiten in der Bauteiloberfläche und ungleichmäßiger Abtrag von Material bei der materialabtragenden Bearbeitung von Bauteiloberflächen nachteilig auf die Qualität der Bauteiloberfläche und somit deren Verwendbarkeit auswirkt. In den bisher bekannten Verfahren zur Oberflächenbehandlung von Bau teilen, insbesondere bei der materialabtragenden Bearbeitung, ist eine gleichmäßige Oberflächenbearbeitung des Bauteils nicht über die gesamte Bauteiloberfläche oder über größere zusammenhängende Bereiche der Bauteiloberfläche gewährleistet. Vor allem bei Bauteilen mit einer komplexen Bauteilgeometrie, insbesondere mit einer gekrümmten Bauteiloberfläche, führt die Krümmung zu einer lokalen Variation der Strahlparameter. Beispielsweise führt eine komplexe Bauteilgeometrie zu einer Variation des Strahlabstands, d.h. des Abstands von der Partikelquelle zur zu behandelnden Bauteiloberfläche, was z.B. zu unterschiedlichen Oberflächenrauhigkeiten in verschiedenen Bereichen der Bauteiloberfläche führt. Dies trifft vor allem für die Bereiche der Bauteiloberfläche zu, die ein unterschiedliches Krümmungsverhalten aufweisen. Ferner sind jene Bereiche der Bauteiloberfläche mit einem sich lokal stark ändernden Krümmungsverhalten sowie diejenigen Bereiche, die für den Partikelstrahl gemäß den herkömmlichen Verfahren schwer zugänglich sind, mit Unregelmäßigkeiten (Inhomogenitäten) in der Oberflächenstruktur behaftet. Bei der Oberflächenbehandlung einer Vielzahl von Bauteilen ist darüber hinaus eine Reproduzierbarkeit nur begrenzt gewährleistet.

Mit dem Verfahren werden erstmals charakteristische Strahlparameter des Partikelstrahls in Bezug auf die lokale Bauteilgeometrie berücksichtigt. Dabei bezeichnet der Einstrahlabstand den Abstand von der Partikelquelle zu dem Auftreffpunkt des Partikelstrahls auf der Bauteiloberfläche. Der Einstrahlwinkel wird in einem lokalen bauteilbezogenen Koordinatensystem definiert. In diesem Bezugssystem ist der Einstrahlwinkel der Winkel zwischen der Einstrahlrichtung des Partikelstrahls und der lokalen Normalen auf die Bauteiloberfläche im Auftreffpunkt des Partikelstrahls auf die Bauteiloberfläche. Unter der Einstrahlintensität versteht man die Anzahl der pro Sekunde und Raumwinkel aus der Partikelquelle emittierten Partikel, d.h. die Einstrahlintensität wird als Partikelfluß angegeben. Die Anzahl der Partikel, die pro Sekunde auf einen lokalen Oberflächenbereich auf der Bauteiloberfläche auftrifft, ergibt sich daraus in einfacher Weise aus dem Einstrahlabstand, der Größe des Oberflächenbereichs sowie dem Einstrahlwinkel. Unter der Einstrahldauer versteht man die Verweilzeit des Partikelstrahls auf einem ausgewählten Abschnitt der Konturlinie. Mittels der Geschwindigkeit, mit der der Partikelstrahl entlang der Konturlinie geführt ist, ist die Verweilzeit des Partikelstrahls und damit die Anzahl der lokal auf die Bauteiloberfläche auftreffenden Partikel variierbar. Mit dem Verfahren ist der Materialabtrag von der Bauteiloberfläche gezielt an die Geometrie des Bauteils angepaßt. Damit ist entlang der Konturlinie eine vorgebbare homogene Oberflächenrauhigkeit herstellbar. Durch Hintereinanderausführung des Abfahrens mehrerer zusammenhängender Konturlinien können große Bereiche der Bauteiloberfläche behandelt und hinsichtlich ihrer Rauhigkeit homogenisiert werden. Insbesondere kann die gesamte Bauteiloberfläche einer solchen Oberflächenbehandlung unterzogen werden.

Für eine effiziente Anwendung des Verfahrens wird man das Verfahren bevorzugt kontinuierlich betreiben. Dazu wird der Partikelstrahl als eine kontinuierliche Funktion der Zeit entlang der Konturlinie geführt. Alternativ dazu könnte man auch den Abtrag von Material von der Bauteiloberfläche entlang der Konturlinie in Intervallen durchführen, wobei das Verfahren temporär unterbrochen wird. Mit dem Verfahren ist es möglich, die Oberflächenrauhigkeits-Kenngrößen, z.B. maximale Profilhöhe, maximale Profiltiefe, Mittenrauhwert, gezielt einzustellen. Der Mittenrauhwert, also das arithmetische Mittel der absoluten Werte der Profilabweichungen innerhalb einer Bezugsstrecke (z.B. eines Teilabschnitts einer Konturlinie) wird hierbei bevorzugt zum Vergleich von Oberflächen gleichen oder ähnlichen Charakters verwendet.

Es ist auch möglich, verschiedene Teilbereiche der Bauteiloberfläche, die beispielsweise unterschiedlich gekrümmt oder orientiert sein können, gezielt mit untereinander verschiedenen, vorgebbaren Oberflächenrauhigkeiten herzustellen. Jeder Teilbereich weist dabei eine homogene Oberflächenrauhigkeit auf. Wo dies sinnvoll und vorgesehen ist, könnte man auch entlang einer Konturlinie die Oberflächenrauhigkeit gemäß einer vorgebbaren, gegebenenfalls nicht-konstanten, Funktion einstellen.

Mittels der an die Konturlinie angepaßten Bestrahlung mit dem Partikelstrahl erfolgt eine Glättung der Bauteiloberfläche zur Einstellung einer vorgegebenen Oberflächenrauhigkeit in einem vorgegebenen Bereich der Bauteiloberfläche. Weiterhin kann das Bestrahlen mit dem Partikelstrahl zu einer Oberflächenreinigung der Bauteiloberfläche verwendet werden, durch die eine Aktivierung der Bauteiloberfläche erreicht wird. Dadurch ist die Bauteiloberfläche für andere sich an die Oberflächenbehandlung anschließende Verfahren - etwa Beschichtungsverfahren - präpariert.

Bevorzugterweise erfolgt die Anpassung der Strahlparameter automatisch. Somit ist eine gute Reproduzierbarkeit gewährleistet. Darüber hinaus sind manuelle Eingriffe in das Verfahren nicht mehr erforderlich.

Vorzugsweise werden die Partikelquelle und das Bauteil relativ zueinander bewegt. Dabei sind relative Translationen, relative Rotationen oder Kombinationen aus Translationen oder Rotationen vorgesehen. Durch diese relative Bewegung von Partikelquelle und Bauteil ist es möglich, den Partikelstrahl an eine gewünschte Stelle und entlang einer Konturlinie auf der Bauteiloberfläche zu führen. Durch die Geschwindigkeit, mit der die Relativbewegungen durchgeführt werden, kann die Einstrahldauer variiert werden. Insbesondere bei Bauteilen mit einer komplexen Bauteilgeometrie, beispielsweise mit einer gekrümmten Bauteiloberfläche, werden durch die Relativbewegungen Strahlparameter, wie beispielsweise Einstrahlwinkel und Einstrahlabstand, beeinflußt. Es sind eine Vielzahl von Betriebsmodi hinsichtlich der Relativbewegungen von Bauteil und Partikelquelle möglich. Einige bevorzugte Ausgestaltungen in dem Verfahren sind im folgenden ausgeführt:

In einer bevorzugten Ausgestaltung des Verfahrens wird die Partikelquelle relativ zu dem Bauteil so bewegt, daß der Einstrahlabstand konstant ist. Dadurch ist bei konstanter Einstrahl.intensität der Partikelquelle die Anzahl der Partikel, die pro Sekunde auf ein senkrecht im konstanten Einstrahlabstand angeordnetes Flächenelement der Bauteiloberfläche auftreffen, ein konstanter Wert. Weiter bevorzugt wird die Partikelquelle relativ zu dem Bauteil so bewegt, daß der Einstrahlwinkel konstant ist. Wählt man einen Betriebsmodus, bei dem sowohl der Einstrahlabstand als auch der Einstrahlwinkel konstant sind, so wird ein besonders an die Geometrie des Bauteils angepaßter Materialabtrag sichergestellt, insbesondere ist eine homogene Oberflächenbehandlung des Bauteils dadurch möglich.

Die Relativbewegungen werden so ausgeführt, daß in einer bevorzugten Verfahrensausgestaltung die Partikelquelle mehrachsig gegenüber dem gleichzeitig ruhenden Bauteil bewegt wird. Mehrachsig bedeutet in diesem Zusammenhang, daß die Partikelquelle entlang mindestens zweier kartesischer Koordinatenachsen bewegt wird. Durch die Kombination von Bewegungen in einer ersten und in einer darauf senkrechten zweiten Achse sind auch Rotationen der Partikelquelle um eine Rotationsachse, etwa um eine Achse, die durch das Bauteil verläuft (z.B. Figurenachse), möglich. Weiter bevorzugt wird die Partikelquelle mehrachsig gegenüber dem gleichzeitig rotierenden Bauteil bewegt. Weiter bevorzugt wird die Partikelquelle mehrachsig gegenüber dem gleichzeitig mehrachsig bewegten Bauteil bewegt.

Vorzugsweise wird das Bauteil mehrachsig gegenüber der gleichzeitig ruhenden Partikelquelle bewegt. Durch die Vielzahl der verschiedenen Verfahrensausgestaltungen hinsichtlich der Relativbewegungen ist eine große Flexibilität gegeben.

Durch die Kombination der verschiedenen Bewegungsmodi können sehr komplexe Bauteilgeometrien in dem Verfahren einer Oberflächenbehandlung unterzogen werden.

Vorzugsweise weist das Bauteil einen Grundkörper mit einem Grundmaterial auf, wobei der Grundkörper die Bauteiloberfläche aufweist, welche für eine auf den Grundkörper aufzubringende erste Beschichtung mit einem ersten Beschichtungsmaterial behandelt wird. Durch das Bestrahlen mit einem Partikelstrom findet eine Oberflächenreinigung des Grundkörpers statt. Diese Oberflächenreinigung bewirkt eine Aktivierung der Oberfläche. Dadurch ist eine besonders gute Anbindung einer ersten Beschichtung auf den Grundkörper in einem Beschichtungsprozeß möglich. Das Verfahren kann somit als Teilverfahren eines Herstellungsverfahrens einer Schicht auf einem Bauteil eingesetzt werden. Das Verfahren ermöglicht eine qualitativ hochwertige Präparation der Bauteiloberfläche vor einer Beschichtung. Dies wirkt sich sehr vorteilhaft auf die auf den Grundkörper aufzubringende Beschichtung aus, vor allem auf deren Haftvermögen und Schichtqualität. Der Grundkörper ist beispielsweise aus einem metallischen Werkstoff hergestellt. Bei Hochtemperaturanwendungen werden hierbei hochtemperaturfeste Legierungen, beispielsweise Nickel-, Kobalt- oder Chrom-Superlegierungen als Werkstoff für den Grundkörper eingesetzt.

Vorzugsweise wird dann in dem Beschichtungsprozeß als erstes Beschichtungsmaterial eine Legierung oder eine intermetallische Verbindung verwendet. Als erstes Beschichtungsmaterial wird bevorzugt eine haftvermittlerschichtbildende Legierung eingesetzt, wie z.B. eine Legierung der Art MCrAlX. Hierbei steht M für ein Metall, insbesondere für ein oder mehrere Elemente der Gruppe umfassend Nickel, Kobalt und Eisen. Cr steht für Chrom und Al für Aluminium. X steht für eines oder mehrere Elemente aus der Gruppe Yttrium, Rhenium sowie die Elemente der Seltenen Erden, wie beispielsweise Hafnium. Solche Legierungen sind insbesondere in Hochtemperaturanwendungen vorgesehen.

Bevorzugt weist die erste Beschichtung auch die Bauteiloberfläche auf, welche für eine auf das Bauteil aufzubringende zweite Beschichtung, mit einem zweiten Schichtmaterial, behandelt wird.

In einer bevorzugten Ausgestaltung weist das Bauteil einen Grundkörper mit einem Grundmaterial auf, wobei auf dem Grundkörper eine erste Beschichtung mit einem ersten Beschichtungsmaterial aufgebracht ist, wobei das beschichtete Bauteil für eine auf das Bauteil aufzubringende zweite Beschichtung, mit einem zweiten Beschichtungsmaterial, behandelt wird. Vorteilhafterweise ist das Verfahren nicht nur dazu geeignet die Oberfläche eines Grundkörpers zu behandeln, sondern das Verfahren kann auch zur Behandlung und Präparation einer auf den Grundkörper aufgebrachten Schicht vor dem Aufbringen einer weiteren Schicht auf die erstere Schicht eingesetzt werden. Das Verfahren ist somit in einen Prozeß zur Herstellung eines Schichtsystems auf einem Bauteil integrierbar. Dadurch können qualitativ sehr hochwertige, vor allem ausreichend langzeitstabile, Schichtsysteme mit einer komplexen Geometrie des Grundkörpers deutlich besser hergestellt werden.

Vorzugsweise wird in dem Beschichtungsprozeß als zweites Beschichtungsmaterial eine Keramik verwendet. Als keramische Materialien kommen beispielsweise solche in Frage, die Zirkonoxid (ZrO₂), welches durch Yttriumoxid, Ceroxid oder ein anderes Oxid teil- oder vollstabilisiert ist, umfassen. Eine solche, eine Keramik aufweisende zweite Beschichtung, ist beispielsweise eine Wärmedämmschicht und weist als solche eine Schichtdicke von etwa > 50 µm, insbesondere etwa > 200 µm auf. Eine Wärmedämmschicht kann auch andere metallkeramische Oxide, insbesondere auch metallkeramische Mischoxidsysteme, beispielsweise Perowskite (z.B. Lanthanaluminat), Pyrochlore (z.B. Lanthanhafnat) oder Spinelle, wie beispielsweise das klassische Magnesium-Aluminatspinell MgAl₂O₄, aufweisen.

Ein Schichtsystem auf einem metallischen Grundkörper, das eine Haftvermittlerschicht als erste Beschichtung und eine sich an die Haftvermittlerschicht anschließende Wärmedämmschicht als zweite Beschichtung aufweist, wird insbesondere bei Hochtemperaturanwendungen eingesetzt. In einer bevorzugten Ausgestaltung des Verfahrens ist das Bauteil für eine Umströmung mit einem heißen Gas ausgelegt. Weiter bevorzugt wird als Bauteil eine Turbinenlaufschaufel, eine Turbinenleitschaufel oder ein Hitzeschildelement einer Brennkammer verwendet. Bauteile von thermischen Maschinen, wie beispielsweise einer Gasturbine, einem Verbrennungsmotor, einem Ofen oder ähnlichem müssen für die Beaufschlagung mit einem heißen aggressiven Medium, insbesondere einem Heißgas, ausgelegt sein. Die Temperaturen, welche ein Bauteil während eines normalen Einsatzes ausgesetzt sind, können hierbei deutlich über 1000 °C liegen.

Vorzugsweise weist der Partikelstrahl Abrasivpartikel auf, die in einem druckbeaufschlagten Trägermedium, insbesondere Preßluft, mitgeführt werden. Die Abrasivpartikel treffen vorzugsweise unter einem Einstrahlwinkel auf die Bauteiloberfläche von etwa 20° bis 90°, insbesondere von etwa 50° bis 90°, auf. Der Durchmesser der Abrasivpartikel, der Einstrahlwinkel sowie der Druck des druckbeaufschlagten Trägermediums richten sich nach dem Material der Abrasivpartikel, dem Material der Bauteiloberfläche, auf die sie auftreffen, sowie der zu erzielenden Wirkung, insbesondere hinsichtlich Oberflächenreinigung oder Materialabtrag, um eine gewünschte Oberflächenrauhigkeit einzustellen. Wird ein hoher Materialabtrag gewünscht, so ist der Winkel, unter dem die Abrasivpartikel auf die Oberfläche auftreffen etwa zwischen 50° bis 90°, insbesondere etwa 60°. Für eine Reinigung und Aktivierung der Bauteiloberfläche liegt der Winkel in einem Bereich zwischen 20° und 60°. Die Abrasivpartikel, die in dem Trägermedium mitgeführt werden, können in Form eines Pulvers bereitgestellt werden oder, falls größere Partikel vorliegen (globulare Form), durch einen Mahlprozeß zerrieben werden, um scharfkantige Abrasivpartikel zu erzeugen, die dann verstärkt abrasiv auf der Bauteiloberfläche wirken.

Die auf einer Vorrichtung zur Oberflächenbehandlung eines Bauteils gerichtete Aufgabe wird erfindungsgemäß gelöst durch eine Strahlanlage zur automatisierten Oberflächenbehandlung eines Bauteils mit einer gekrümmten Bauteiloberfläche, die eine Bauteilhalterung, die um eine Drehachse drehbar ist, zur Aufnahme des Bauteils aufweist sowie mindestens eine Partikelquelle zur Erzeugung eines Partikelstrahls, die durch Bewegung nur entlang einer horizontalen Achse sowie entlang einer vertikalen Achse relativ zu dem Bauteil führbar und drehbar um eine Rotationsachse ist, die sich senkrecht zu einer von der vertikalen Achse und der horizontalen Achse aufgespannten Ebene erstreckt, wobei die Partikelquelle und das Bauteil durch ein Steuersystem so relativ zueinander bewegt werden, daß zur Herstellung einer homogenen Bauteiloberfläche in einem Abstrahlprozeß mittels des Partikelstrahls der Einstrahlabstand und/oder der Einstrahlwinkel entlang einer Konturlinie auf der Bauteiloberfläche einen vorgegebenen, insbesondere konstanten, Wert einnimmt.

Anhand der in der Zeichnung dargestellten Ausführungsbeispiele wird das Verfahren und die Vorrichtung näher erläutert. Es zeigen hierbei teilweise nicht maßstäblich und schematisch
- FIG 1 bis FIG 3: einen Ausschnitt eines Grundkörpers eines Bauteils mit freier, insbesondere gekrümm ter, Bauteiloberfläche,
- FIG 4: einen Ausschnitt durch ein Bauteil, bei dem auf einen Grundkörper eine erste Beschichtung aufgebracht ist,
- FIG 5: einen Ausschnitt durch ein Bauteil, bei dem auf einen Grundkörper eine erste und eine zweite Beschichtung aufgebracht sind,
- FIG 6: eine Turbinenschaufel in perspektivischer Darstellung,
- FIG 7: ein Hitzeschildelement einer Brennkammer in perspektivischer Darstellung,
- FIG 8: eine Strahlanlage zur Oberflächenbehandlung mit einem in der Strahlanlage angeordneten Bauteil.

Gleiche Bezugszeichen haben in den Figuren die gleiche Bedeutung.

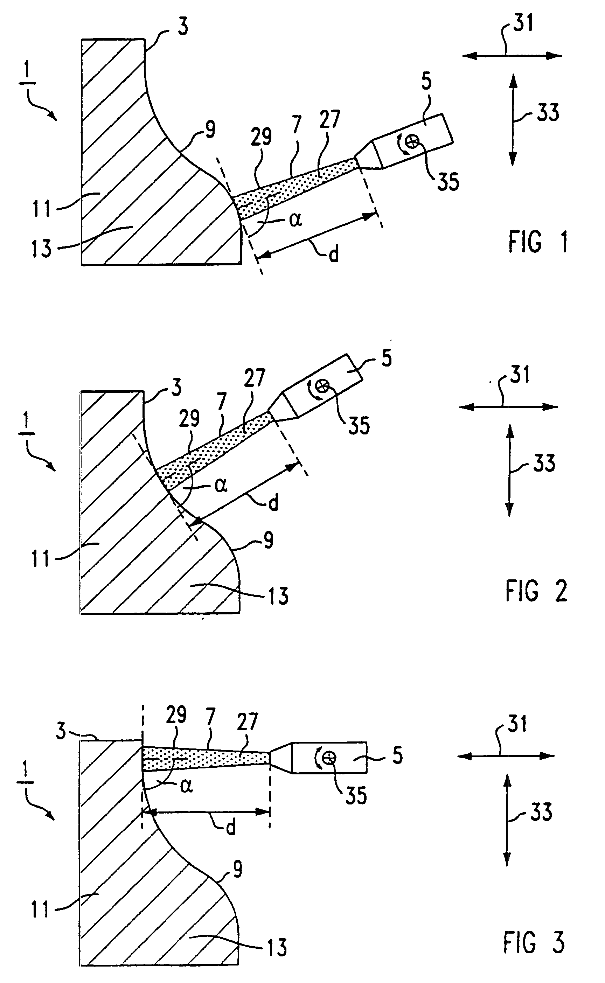

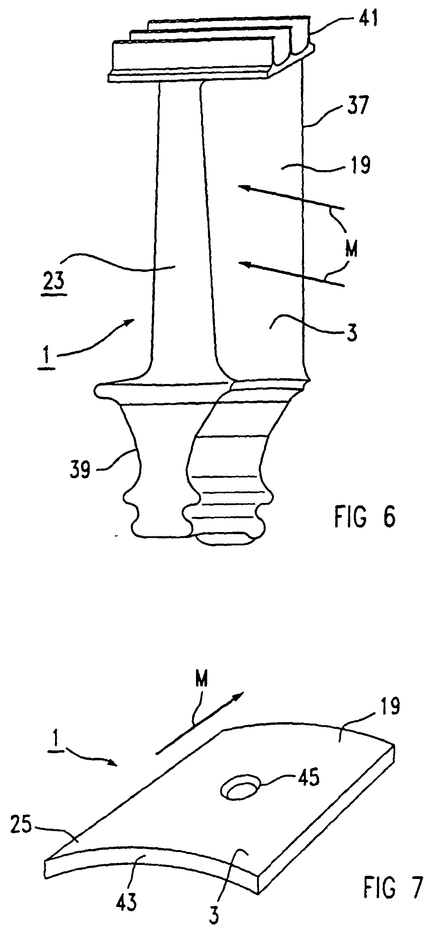

In Figur 1 ist ein Ausschnitt durch einen Grundkörper 11 eines nicht näher dargestellten Bauteils 1 (siehe z.B. Figur 6 oder 7) mit einem Grundmaterial 13, insbesondere einer Nickel- oder Kobalt-Superlegierung dargestellt. Der Grundkörper 11 weist eine Bauteiloberfläche 3 auf. Zur Oberflächenbehandlung der Bauteiloberfläche 3, etwa zur Vorbehandlung vor Aufbringen einer Beschichtung auf die Bauteiloberfläche 3, wird de Bauteiloberfläche 3 mit Abrasivpartikeln 27 aus einem Partikelstrahl 7 bestrahlt, die in einem druckbeaufschlagten Trägermedium 29, insbesondere Druckluft 29, mitgeführt werden. Zur Erzeugung eines solchen Partikelstrahls mit dem Trägermedium 29 und mit den darin mitgeführten Abrasivpartikeln 27 ist eine Partikelquelle 5 vorgesehen. Die Behandlung der Bauteiloberfläche 3 mit Abrasivpartikeln 27 dient einer Glättung der Bauteiloberfläche 3, wobei eine vorgegebene Oberflächenrauhigkeit hergestellt wird. Darüber hinaus dient die Bestrahlung der Bauteiloberfläche einer Reinigung und Aktivierung der Bauteiloberfläche. Dazu treffen die Abrasivpartikel 27 auf die Bauteiloberfläche 3 unter einem Winkel α auf. Die Abrasivpartikel 27 bestehen hierbei vorzugsweise aus dem Grundmaterial 13 oder aus einem Material, welches gleich einem Beschichtungsmaterial ist, welches im Anschluß an die Bestrahlung mit den Abrasivpartikeln 27 auf den Grundkörper 11 aufzubringen ist. Zur Erzielung einer gewünschten, insbesondere homogenen, Oberflächenrauhigkeit ist die Partikelquelle 5 gegenüber dem Bauteil 1 beweglich. Die Partikelquelle 5 kann Bewegungen entlang einer horizontalen Achse 31 sowie entlang einer vertikalen Achse 33 relativ zu dem Bauteil 1 ausführen. Weiterhin kann die Partikelquelle 5 Rotationen um eine Rotationsachse 35 ausführen. Die Rotationsachse 35 erstreckt sich senkrecht zu einer von der vertikalen Achse 33 und der horizontalen Achse 31 aufgespannten Ebene. Damit ist der Partikelstrahl 7, welcher aus der Partikelquelle 5 emittiert wird, entlang einer Konturlinie 9 auf der Bauteiloberfläche 3 führbar. Insbesondere können unterschiedliche Bereiche auf der Bauteiloberfläche 3 entlang der Konturlinie 9 der materialabtragenden Bearbeitung durch die Abrasivpartikel 27 unterzogen werden. Zur Erzielung einer homogenen Oberflächenrauhigkeit werden die Strahlparameter hierbei gezielt an die Konturlinie angepaßt. Dies ist in den Figuren 1 bis 3 dargestellt, die eine chronologische Abfolge der Oberflächenbehandlung entlang der Konturlinie 9 zeigen. Dabei wird die Partikelquelle 5 relativ zu dem Bauteil 1 so bewegt, daß der Einstrahlabstand d konstant ist. Zugleich wird die Partikelquelle 5 relativ zu dem Bauteil 1 so bewegt, daß der Einstrahlwinkel α konstant ist. Dadurch können unterschiedliche Bereiche der Bauteiloberfläche 3 entlang der Konturlinie 9 gleichermaßen behandelt werden. Während in Figur 1 ein konvex gewölbter Bereich der Konturlinie 9 von dem Partikelstrahl 7 behandelt wird, trifft in Figur 2 der Partikelstrahl 7 auf einen konkav gekrümmten Bereich der Konturlinie 9. In Figur 3 findet die materialabtragende Bearbeitung der Bauteiloberfläche 3 in einem Bereich der Konturlinie 9 statt, die annähernd planar ist. Die Ansteuerung der Partikelquelle 5 erfolgt automatisch. Dabei kann beispielsweise die genaue Bauteilgeometrie, insbesondere die Bauteiloberfläche, durch ein nicht dargestelltes Meßsystem erfaßt werden und diese Istdaten mit Solldaten verglichen werden. Diese Datensätze können als Eingabedaten für ein nicht dargestelltes Steuerungssystem dienen, welcher die Partikelquelle 5 hinsichtlich der Strahlparameter relativ zu dem Bauteil 1 ansteuert. Dadurch ist eine automatische Oberflächenbehandlung des Bauteils 1 gegeben.

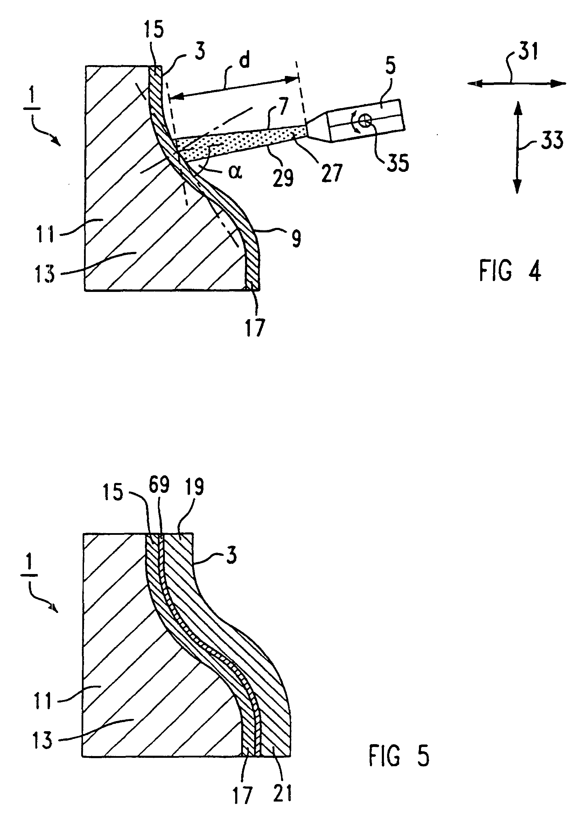

In Figur 4 ist der Grundkörper 11 aus den Figuren 1 bis 3 dargestellt, wobei auf den Grundkörper 11 eine erste Beschichtung 15 mit einem ersten Beschichtungsmaterial 17 aufgebracht wurde. Die erste Beschichtung ist vorzugsweise eine Haftvermittlerschicht und wurde mittels eines physikalischen Aufdampfverfahrens, beispielsweise Elektronenstrahl-Dampfabscheidung (EB-PVD, Electron Beam Physical Vapor Deposition) oder einem Plasmaspritz-Verfahren aufgebracht. Die erste Beschichtung 15 weist ein erstes Beschichtungsmaterial 17 auf, welches insbesondere beim Beschichten eines Gasturbinenbauteils eine Legierung der Art MCrAlX oder ein Aluminid ist. Durch die erste Beschichtung 15 ist nunmehr eine Bauteiloberfläche 3 des Bauteils 1 an der dem Grundkörper 11 abgewandten Seite der Beschichtung 15 gebildet. Diese Bauteiloberfläche 3 wird nunmehr für das Aufbringen einer zweiten Beschichtung 19 vorbereitet. Hierzu wird die Oberfläche 3 mit Abrasivpartikeln 27 aus der Partikelquelle 5 bestrahlt. Die Abrasivpartikel 27 werden in einem Partikelstrahl 7 in einem druckbeaufschlagten Trägermedium 29 mitgeführt. Vorzugsweise wird als Trägermedium 29 Preßluft verwendet. Die Abrasivpartikel 27 treffen auf die Bauteiloberfläche 3 unter einem Einstrahlwinkel α auf, welcher dem Einstrahlwinkel α bei der Bestrahlung des Grundkörpers 11 gemäß den Figuren 1 bis 3 entspricht oder von diesem abweicht. Die konkrete Wahl des Einstrahlwinkels α sowie des Einstrahlabstands d sowie des Drucks durch den das Trägermedium 29 beaufschlagt ist, hängen von der Art des Materials der Abrasivpartikel 27, der Art des ersten Beschichtungsmaterials 17 sowie beispielsweise noch von einer zu erzielenden Oberflächenrauhigkeit oder Reinigung der Bauteiloberfläche 3 ab. Bei der materialabtragenden Oberflächenbehandlung der Schicht 15 wird der Partikelstrahl 7 entlang einer Konturlinie 9 derart geführt, daß sich entlang der Konturlinie eine zu erzielende, im allgemeinen homogene. Oberflächenrauhigkeit einstellt. Mit dem Verfahren können insbesondere Konturlinien 9, welche auf gekrümmten Bauteiloberflächen 3 vorhanden sind, mit hoher Qualität und Reproduzierbarkeit bearbeitet werden. Von Vorteil ist, daß die erste Beschichtung 15 bereits mit einem hohen Anbinduncrsvermögen und einer hohen Zeitstandfestigkeit auf den Grundkörper 11 durch das Verfahren hergestellt wird.

Figur 5 zeigt einen Ausschnitt durch das Erzeugnis 1, wobei auf den Grundkörper 11 neben der ersten Beschichtung 15 noch eine zweite Beschichtung 19 mit einem zweiten Beschichtungsmaterial 21 aufgebracht ist. Zwischen der zweiten Beschichtung 19, welche bei einem Bauteil einer Gasturbine vorzugsweise eine Wärmedämmschicht aus einem Metalloxid oder einem Metallmischoxidsystem ist, beispielsweise teil- oder vollstabilisiertes Zirkonoxid, ist eine Oxidschicht 69 als Zwischenschicht 69 angeordnet. Diese Oxidschicht 35 weist Aluminiumoxid und/oder Chromoxid auf und kann infolge thermischer Oxidation der ersten Beschichtung 15 gebildet worden sein (thermisch gewachsenes Oxid, TGO) oder wurde in einem Zwischenschritt auf die erste Beschichtung 15 aufgebracht. Das Verfahren kann somit bei Schichtsystemen auf Bauteilen 1 mit komplexer Bauteilgeometrie mit komplexer Bauteilgeometrie, insbesondere mit einer gekrümmten Bauteiloberfläche 3 angewendet werden. Die Qualität eines Schichtsystems wird dadurch erheblich verbessert.

Figur 6 zeigt in einer perspektivischen Ansicht ein Bauteil 1, hier eine Turbinenlaufschaufel 23, welche einen Schaufelblattbereich 37 aufweist, der mit einer Beschichtung 19, einer Wärmedämmschicht, beschichtet ist. Der Schaufelblattbereich 37 wird während des Betriebs der Turbinenschaufel 23, etwa in einer nicht dargestellten Gasturbine, von einem heißen aggressiven Medium M, insbesondere einem Heißgas M, welches durch Verbrennung eines Brennstoffs entsteht, umströmt. An den Schaufelblattbereich 37 grenzt einerseits ein Befestigungsbereich 39 an, in dem die Turbinenlaufschaufel 23 der Gasturbine befestigt ist, und andererseits eine Deckplatte 41, die zur Abdichtung der Turbinenlaufschaufel 23 gegenüber einer weiteren nicht dargestellten Komponente der Gasturbine dient. Die Turbinenlaufschaufel 23 weist eine Bauteiloberfläche 3 auf, welche eine komplexe Bauteilgeometrie mit Bereichen stark unterschiedlichen Krümmungsverhaltens zeigt.

In Figur 7 ist in einer perspektivischen Darstellung ein Bauteil 1, ein Hitzeschildelement 25 einer nicht dargestellten Brennkammer einer Gasturbine gezeigt. Das Hitzeschildelement 25 weist ein Abdeckelement 43 mit einem zentrisch darin angeordneten Verbindungsloch 45 auf. Durch das Verbindungsloch 45 ist das Abdeckelement 43 über ein nicht dargestelltes Verbindungselement führbar und das Hitzeschildelement 25 an einer nicht dargestellten Wand der Brennkammer befestigbar. Eine Brennkammer einer Gasturbine ist mit einer Vielzahl solcher Hitzeschildelemente 25 ausgekleidet. Ebenso wie die in Figur 6 gezeigte Turbinenlaufschaufel 23, weist das Hitzeschildelement 25 eine komplexe, insbesondere gekrümmte, Bauteiloberfläche 3 auf. Während des Einsatzes des Hitzeschildelements 25 ist dieses mit der Wärmedämmschicht 19 einem heißen aggressiven Medium M, insbesondere einem Heißgas M, ausgesetzt.

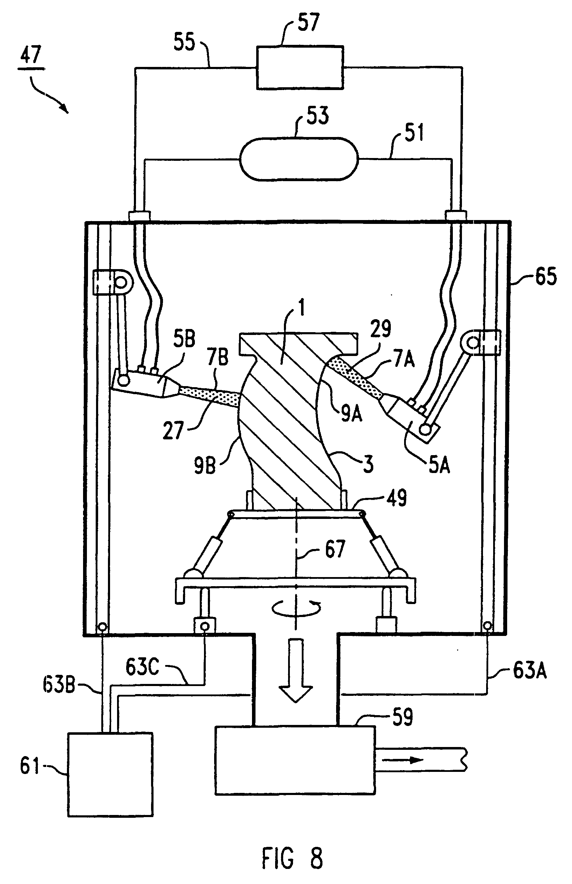

Figur 8 zeigt schematisch und nicht maßstäblich eine Strahlanlage 47 zur automatisierten Oberflächenbehandlung eines Bauteils 1. Die Strahlanlage 47 weist eine Strahlkammer 65 auf, in der eine Bauteilhalterung 49 angeordnet ist. Von der Bauteilhalterung 49 ist ein Bauteil 1 aufgenommen. Das Bauteil 1 weist eine gekrümmte Bauteiloberfläche 3 auf. In der Strahlkammer 65 ist eine erste Partikelquelle 5A sowie eine zweite Partikelquelle 5B angeordnet. Die Partikelquellen 5A, 5B sind so angeordnet, daß sie für einen Bestrahlungsprozeß einander gegenüberliegende Bereiche der Bauteiloberfläche 3 erreichen. Zur Erzeugung eines Partikelstrahls 7A, 7B, der Abrasivpartikel 27 sowie ein Trägermedium 29 aufweist, ist in der Strahlanlage 47 ein Abrasivpartikel-Reservoir 57 sowie ein Trägermedium-Reservoir 53 vorgesehen. Das Trägermedium-Reservoir 53 versorgt die Partikelquelle 5A, 5B über eine erste Versorgungsleitung 51 für Trägermedium 29. Zur Versorgung der Partikelquelle 5A, 5B mit Abrasivpartikeln 27 ist eine Versorgungsleitung 55 für Abrasivpartikel 27 vorgesehen. Darüber hinaus weist die Strahlkammer 65 ein Abströmsystem 59 auf. Das Abströmsystem 59 ist beispielsweise als Saugeinrichtung ausgestattet. Auf diese Weise kann im wesentlichen die gesamte Menge der abrasiv wirkenden Abrasivpartikel 27 wiedergewonnen werden und erneut für eine Bestrahlung verwendet werden. Die Abrasivpartikel 27 können hierbei aus Gußeisen, Stahl, aus synthetischem Korund (Aluminiumoxid, Al₂O₃), Siliciumkarbid oder Silikatsand hergestellt sein. Daneben sind Abrasivpartikel 27 aus Legierungen oder intermetallischen Verbindungen möglich. Die Partikelquelle 5A, 5B und die Bauteilhalterung 49 mit dem Bauteil 1 sind relativ zueinander beweglich. Beispielsweise ist die Partikelquelle 5A, 5B mehrachsig gegenüber dem ruhenden Bauteil 1 beweglich. Andererseits ist das Bauteil 1 über die Bauteilhalterung 49 gegenüber der Partikelquelle 5A, 5B mehrachsig beweglich. Insbesondere ist die Bauteilhalterung 49 mit dem Bauteil 1 um eine vertikale Drehachse 67 drehbar angeordnet. Dies ist vor allem für die materialabtragende Oberflächenbehandlung von rotationssymmetrischen Bauteilen 1 sehr vorteilhaft. Zur automatisierten Oberflächenbehandlung des Bauteils 1 ist die Strahlanlage 47 mit einem Steuersystem 61 ausgestattet. Die Partikelquelle 5A, 5B sowie die Bauteilhalterung 49 sind über jeweilige Steuersignalleitungen 63A, 63B, 63C mit dem Steuersystem 61 verbunden. Auf diese Weise ist eine automatisierte Steuerung der Bewegung von Bauteil 1 und Partikelquelle 5A, 5B möglich. Insbesondere sind die relevanten Strahlparameter der Partikelquelle 5A, 5B automatisch steuerbar, so daß zur Herstellung einer vorzugsweise homogenen Bauteiloberfläche 3 in einem Abstrahlprozeß der Einstrahlabstand d sowie der Abstrahlwinkel α entlang einer Konturlinie 9A, 9B auf der Bauteiloberfläche 3 einen vorgebbaren, vorzugsweise konstanten, Wert einnimmt. Durch die Ausstattung der Strahlanlage 47 mit mehreren Partikelquellen 5A, 5B ist eine simultane Oberflächenbehandlung des Bauteils 1 entlang verschiedener Konturlinien 9A, 9B auf der Bauteiloberfläche 3 möglich.

Bei einem Verfahren zur Oberflächenbehandlung des Bauteils 1 in der automatisierten Strahlanlage 47 wird die Partikelquelle 5A, 5B über die Reservoire 53, 57 mit Abrasivpartikeln 27 sowie mit Trägermedium 29, insbesondere Preßluft 29, versorgt. Durch den mittels der Partikelquellen 5A, 5B erzeugte Partikelstrahl 7A, 7B, welcher durch die Strahlparameter Einstrahlabstand d, Einstrahlwinkel α und Einstrahldauer charakterisiert ist, wird Material von der Bauteiloberfläche 3 entlang einer Konturlinie 9A, 9B auf der Bauteiloberfläche 3 abgetragen. Die Strahlparameter werden gezielt so an die Konturlinie 9A, 9B angepaßt, daß sich entlang der Konturlinie 9A, 9B eine vorgegebene, vorzugsweise homogene, Oberflächenrauhigkeit einstellt. Dabei erfolgt die Anpassung der Strahlparameter automatisch über das Steuersystem 61, welches die Relativbewegung des Bauteils 1 und der Partikelquellen 5A, 5B steuert. Besonders günstig ist die Betriebsweise, bei der die Partikelquelle 5A, 5B relativ zum Bauteil 1 so bewegt wird, daß der Einstrahlabstand d sowie der Einstrahlwinkel α konstant sind. Das Steuersystem 61 sorgt für die präzise Positionierung und Ansteuerung von Bauteil 1 und der Partikelquelle 5A, 5B. Dadurch ist die Oberflächenbehandlung von Bauteilen 1 mit komplexer Geometrie, insbesondere mit gekrümmter Bauteiloberfläche 3, mit hoher Qualität und Reproduzierbarkeit möglich. Dies ist vor allem für eine Serienfertigung von Bauteilen 1 und deren Oberflächenbehandlung von großem Vorteil.

Die Erfindung zeichnet sich dadurch aus, daß die Bauteiloberfläche eines Bauteils, welche insbesondere Bereiche unterschiedlicher Krümmung aufweist, zur Oberflächenbehandlung des Bauteils mit abrasiv wirkenden Partikeln bestrahlt wird. Dadurch wird eine Glättung und/oder eine Reinigung mit gegebenenfalls einer Aktivierung der Bauteiloberfläche erzielt. Das Verfahren ist zur Bearbeitung des Grundkörpers eines Bauteils geeignet sowie zu einer Vorabbearbeitung eines zu beschichtenden Bauteils. Insbesondere ist das Verfahren in ein verfahren zur Herstellung eines Schichtsystems auf einem Grundkörper eines Bauteils integrierbar. Die materialabtragende Bearbeitung der Bauteiloberfläche ist gezielt an die Geometrie des Bauteils angepaßt, wodurch eine homogene Oberflächenbehandlung erreicht ist.

## Patentansprüche

1. Verfahren zur Oberflächenbehandlung eines Bauteils (1) mit einer gekrümmten Bauteiloberfläche (3),
bei dem mittels eines aus einer Partikelquelle (5) erzeugten Partikelstrahls (7),
welcher durch die Strahlparameter Einstrahlabstand (d), Einstrahlintensität, Einstrahlwinkel (α) und Einstrahldauer charakterisiert ist,
Material von der Bauteiloberfläche (3) entlang einer Konturlinie auf der Bauteiloberfläche (3) abgetragen wird,
**dadurch gekennzeichnet, dass**
während der Oberflächenbehandlung zumindest einmal zumindest einer der Strahlparameter gezielt so an die Konturlinie angepaßt wird, dass sich entlang der Konturlinie eine homogene Oberflächenrauhigkeit einstellt.

2. Verfahren nach Anspruch 1,
**dadurch gekennzeichnet, dass** die Anpassung der Strahlparameter automatisch erfolgt.

3. Verfahren nach Anspruch 1 oder 2,
**dadurch gekennzeichnet, dass** die Partikelquelle (5) und das Bauteil (1) relativ zueinander bewegt werden.

4. Verfahren nach Anspruch 1, 2 oder 3,
**dadurch gekennzeichnet, dass** die Partikelquelle (5) relativ zu dem Bauteil (1) so bewegt wird, dass der Einstrahlabstand (d) konstant ist.

5. Verfahren nach einem der vorhergehenden Ansprüche,
**dadurch gekennzeichnet, dass** die Partikelquelle (5) relativ zu dem Bauteil (1) so bewegt wird, dass der Einstrahlwinkel (α) konstant ist.

6. Verfahren nach einem der vorhergehenden Ansprüche,
**dadurch gekennzeichnet, dass** das Bauteil (1) einen Grundkörper (11) mit einem Grundmaterial (13) aufweist, wobei der Grundkörper (11) die Bauteiloberfläche (3) aufweist, welche für eine auf den Grundkörper (11) aufzubringende erste Beschichtung (15), mit einem ersten Beschichtungsmaterial (17), behandelt wird.

7. Verfahren nach Anspruch 6,
**dadurch gekennzeichnet , dass** als erstes Beschichtungsmaterial (17) eine MCrAlX-Legierung verwendet: wird, wobei M für eines oder mehrere Elemente umfassend Eisen, Kobalt und Nickel, Cr für Chrom, Al für Aluminium und X für eines oder mehrere Elemente der Gruppe umfassend Yttrium, Rhenium sowie die Elemente der Seltenen Erden stehen.

8. Verfahren nach Anspruch 6 oder 7
**dadurch gekennzeichnet , dass** die erste Beschichtung (15) auch die Bauteiloberfläche (3) aufweist, welche für eine auf das Bauteil (1) aufzubringende zweite Beschichtung (19), mit einem zweiten Beschichtungsmaterial (21), behandelt wird.

9. Verfahren nach einem der Ansprüche 1 bis 5,
**dadurch gekennzeichnet, dass** das Bauteil (1) einen Grundkörper (11) mit einem Grundmaterial (13) aufweist, wobei auf dem Grundkörper (11) eine erste Beschichtung (15) mit einem ersten Beschichtungsmaterial (17) aufgebracht ist, wobei das beschichtete Bauteil (1) für eine auf das Bauteil (1) aufzubringende zweite Beschichtung (19), mit einem zweiten Beschichtungsmaterial (21), behandelt wird.

10. Verfahren nach Anspruch 8 oder 9,
**dadurch gekennzeichnet, dass** in dem Beschichtungsprozeß als zweites Beschichtungsmaterial (21) eine Keramik verwendet wird.

11. Verfahren nach einem der vorhergehenden Ansprüche,
**dadurch gekennzeichnet, dass** das Bauteil (1) für eine Umströmung mit einem heißen Gas ausgelegt ist.

12. Verfahren nach einem der vorhergehenden Ansprüche,
**dadurch gekennzeichnet, dass** als Bauteil (1) eine Turbinenlaufschaufel (23), eine Turbinenleitschaufel oder ein Hitzeschildelement (25) einer Brennkammer verwendet wird.

13. Verfahren nach einem der vorhergehenden Ansprüche,
**dadurch gekennzeichnet, dass** der Einstrahlwinkel (α) auf die Bauteiloberfläche (3) etwa 20° bis 90°, insbesondere etwa 50° bis 90° beträgt.

14. Strahlanlage (47) zur automatisierten Oberflächenbehandlung eines Bauteils (1) mit einer gekrümmten Bauteiloberfläche (3),
die eine Partikelquelle (5),
die drehbar um eine Rotationsachse (35) ist,
zur Erzeugung eines Partikelstrahls (7), sowie
eine Bauteilhalterung (49) zur Aufnahme des Bauteils (1) aufweist,
die (49) um eine Drehachse (67) drehbar ist,
**dadurch gekennzeichnet,**
**dass** die Partikelquelle (5) durch Bewegung nur entlang einer horizontalen Achse (31) sowie entlang einer vertikalen Achse (33) relativ zu dem Bauteil (1) führbar ist,
**dass** die Rotationsachse (35) sich senkrecht zu einer von der vertikalen Achse (33) und der horizontalen Achse (31) aufgespannten Ebene erstreckt, und dass ein Steuersystem (61)
die Position der Partikelquelle (5) und des Bauteils (1) während der Oberflächenbehandlung so verändert
**dass** zur Herstellung einer homogenen Bauteiloberfläche (3) in einem Abstrahlprozess mittels des Partikelstrahls (17) der Einstrahlabstand (d) und/oder der Einstrahlwinkel (α) entlang einer Konturlinie auf der Bauteiloberfläche (3) einen vorgegebenen, insbesondere konstanten, Wert einnimmt.

15. Strahlanlage nach Anspruch 14,
**dadurch gekennzeichnet, dass**
die Bauteilhalterung (49) gegenüber der Partikelquelle (5) mehrachsig bewegbar ist.

## Claims

1. Method for the surface treatment of a component (1) having a curved component surface (3), in which material is removed from the component surface (3) along a contour line on the component surface (3) by means of a particle jet (7) which is generated from a particle source (5) and is **characterized by** the jet parameters blasting distance (d), blasting intensity, blasting angle (α) and blasting time, **characterized in that** during the surface treatment at least once at least one of the jet parameters is deliberately matched to the contour line in such a way that a homogeneous surface roughness is established along the contour line.

2. Method according to Claim 1, **characterized in that** the matching of the jet parameters takes place automatically.

3. Method according to Claim 1 or 2, **characterized in that** the particle source (5) and the component (1) are moved relative to one another.

4. Method according to Claim 1, 2 or 3, **characterized in that** the particle source (5) is moved relative to the component (1) in such a way that the blasting distance (d) is constant.

5. Method according to one of the preceding claims, **characterized in that** the particle source (5) is moved relative to the component (1) in such a way that the blasting angle (α) is constant.

6. Method according to one of the preceding claims, **characterized in that** the component (1) has a base body (11) with a base material (13), the base body (11) having the component surface (3) which, for a first coating (15) to be applied to the base body (11), is treated with a first coating material (17).

7. Method according to Claim 6, **characterized in that** the first coating material (17) used is an MCrAlX alloy, where M represents one or more elements comprising iron, cobalt and nickel, Cr represents chromium, Al represents aluminium and X represents one or more elements selected from the group consisting of yttrium, rhenium and the rare earths.

8. Method according to Claim 6 or 7, **characterized in that** the first coating (15) also has the component surface (3) which, for a second coating (19) to be applied to the component (1), is treated with a second coating material (21).

9. Method according to one of Claims 1 to 5, **characterized in that** the component (1) has a base body (11) with a base material (13), a first coating (15) comprising a first coating material (17) being applied to the base body (11), and the coated component (1), for a second coating (19) to be applied to the component (1), being treated with a second coating material (21).

10. Method according to Claim 8 or 9, **characterized in that**, in the coating process, a ceramic is used as the second coating material (21).

11. Method according to one of the preceding claims, **characterized in that** the component (1) is designed for a hot gas to flow around it.

12. Method according to one of the preceding claims, **characterized in that** the component (1) used is a turbine rotor blade (23), a turbine guide vane or a heat shield element (25) of a combustion chamber.

13. Method according to one of the preceding claims, **characterized in that** the blasting angle (α) on the component surface (3) is approximately 20° to 90°, in particular approximately 50° to 90°.

14. Blasting installation (47) for the automated surface treatment of a component (1) having a curved component surface (3), which installation has a particle source (5), which can be rotated about an axis of rotation (35), for generating a particle jet (7), and a component holder (49) for holding the component (1), which (49) can be rotated about an axis of rotation (67), **characterized in that** the particle source (5) can be guided relative to the component (1) by moving only along a horizontal axis (31) and along a vertical axis (33), **in that** the axis of rotation (35) extends perpendicularly to a plane encompassed by the vertical axis (33) and the horizontal axis (31) and **in that** a control system (61) modifies the position of the particle source (5) and of the component (1) during the surface treatment in such a way that, to produce a homogeneous component surface (3) in a blasting process using the particle jet (17), the blasting distance (d) and/or the blasting angle (α) adopts a predetermined, in particular constant value along a contour line on the component surface (3).

15. Blasting installation according to Claim 14, **characterized in that** the component header (49) is movable in a plurality of axes with respect to the particle source (5).

## Revendications

1. Procédé de traitement de surface d'un élément (1) ayant une surface (3) courbe,
dans lequel on enlève, au moyen d'un jet (7) de particules produit à partir d'une source (5) de particules,
qui est **caractérisé par** les paramètres de jet, distance (d) de projection, intensité de projection, angle (α) de projection et durée de projection,
de la matière de la surface (3) de l'élément le long d'une ligne de contour à la surface (3) de l'élément,
**caractérisé en ce que**
pendant le traitement de surface, on adapte au moins une fois l'un des paramètres de projection de manière ciblée à la ligne de contour, de façon à établir une rugosité de surface homogène le long de la ligne de contour.

2. Procédé suivant la revendication 1,
**caractérisé en ce que** l'adaptation du paramètre de projection s'effectue automatiquement.

3. Procédé suivant la revendication 1 ou 2,
**caractérisé en ce que** l'on déplace la source (5) de particules et l'élément (1) l'un par rapport à l'autre.

4. Procédé suivant la revendication 1 ou 2 ou 3,
**caractérisé en ce que** l'on déplace la source (5) de particules par rapport à l'élément (1) de façon à maintenir constante la distance (d) de projection.

5. Procédé suivant l'une des revendications précédentes,
**caractérisé en ce que** !'on déplace la source (5) de particules par rapport à l'élément (1) de façon à ce que l'angle (α) de projection soit constant.

6. Procédé suivant l'une des revendications précédentes,
**caractérisé en ce que** l'élément (1) a une pièce de base (11) en un matériau (13) de base, la pièce de base (11) comportant la surface (3) de l'élément qui, pour avoir un premier revêtement (15) déposé sur la pièce de base (11), est traité par un premier matériau (17) de revêtement.

7. Procédé suivant la revendication 6,
**caractérisé en ce que** l'on utilise comme premier matériau (17) de revêtement un alliage MCrAlX, M représentant un ou plusieurs éléments comprenant le fer, le cobalt et le nickel, Cr représentant le chrome, Al représentant l'aluminium et X représentant un ou plusieurs éléments du groupe comprenant l'yttrium, le rhénium, ainsi que les éléments des terres rares.

8. Procédé suivant la revendication 6 ou 7,
**caractérisé en ce que** le premier revêtement (15) présente aussi la surface (3) de l'élément qui, pour un deuxième revêtement (19) à déposer sur l'élément (1), est traité par un deuxième matériau (21) de revêtement.

9. Procédé suivant l'une des revendications 1 à 5,
**caractérisé en ce que** l'élément (1) a une pièce de base (11) ayant un matériau (13) de base, un premier revêtement (15) ayant un premier matériau (17) de revêtement étant déposé sur la pièce de base (11), l'élément (1) revêtu étant pour un deuxième revêtement (19) à déposer sur l'élément (1) traité par un deuxième matériau (21) de revêtement.

10. Procédé suivant la revendication 8 ou 9,
**caractérisé en ce que** l'on utilise dans l'opération de revêtement, comme deuxième matériau (21) de revêtement, une céramique.

11. Procédé suivant l'une des revendications précédentes,
**caractérisé en ce que** l'élément (1) est conçu pour que du gaz chaud y soit dévié.

12. Procédé suivant l'une des revendications précédentes,
**caractérisé en ce que** l'on utilise comme élément (1) une aube (23) mobile de turbine, une aube directrice de turbine ou un élément (25) formant bouclier thermique d'une chambre de combustion.

13. Procédé suivant l'une des revendications précédentes,
**caractérisé en ce que** l'angle (α) de projection sur la surface (3) de l'élément est compris entre environ 20° et 90°, et notamment entre environ 50° et 90°.

14. Installation (47) de projection pour le traitement de surface automatisé d'un élément (1) ayant une surface (3) courbée qui comprend :
une source (5) de particules,
qui est montée tournante par rapport à un axe (35) de rotation,
pour la production d'un jet (7) de particules, ainsi qu'
un dispositif (49) de maintien, destiné à la réception de l'élément (1 ),
qui (49) est monté toumant par rapport à un axe (67) de rotation,
**caractérisé**
**en ce que** la source (5) de particules peut être guidée par rapport à l'élément (1) par déplacement seulement le long d'un axe (31) horizontal, ainsi que le long d'un axe (33) vertical,
**en ce que** l'axe (35) de rotation s'étend perpendiculairement à un plan passant par l'axe (33) vertical et par l'axe (31) horizontal et en ce qu'un système (61) de commande modifie la position de la source (5) de particules et de l'élément (1) pendant le traitement de surface, de façon à ce que, pour produire une surface (3) homogène de l'élément dans une opération de projection au moyen du jet (17) de particules, la distance (d) de projection et/ou l'angle (α) de projection prenne une valeur prescrite, notamment constante, le long d'une ligne de contour sur la surface (3) de l'élément.

15. Installation de projection suivant la revendication 14,
**caractérisé en ce que**
le dispositif (49) de maintien de l'élément peut être déplacé suivant plusieurs axes par rapport à la source (5) de particules.
